# EUROPEAN PATENT SPECIFICATION

(11) **EP 2 798 031 B1**
(45) Date of publication and mention of the grant of the patent: **20.02.2019**
(21) Application number: 12861219.9
(22) Date of filing: 30.12.2012
(51) Int. Cl.: C09K 3/14, C09C 1/68, C09G 1/02, B24D 3/18, B24D 18/00

(54) **ABRASIVE ARTICLES AND METHOD OF FORMING SAME**
SCHLEIFKÖRPER UND VERFAHREN ZU IHRER HERSTELLUNG
ARTICLES ABRASIFS ET PROCÉDÉ POUR LEUR FABRICATION

(30) Priority: 30.12.2011 US 201161582048 P
(43) Date of publication of application: 05.11.2014
(73) Proprietor: Saint-Gobain Abrasives, Inc., Worcester, MA 01615-0138 (US); Saint-Gobain Abrasifs, 78700 Conflans-Sainte-Honorine (FR)
(72) Inventor: SIVASUBRAMANIAN, Shivshankar, Lowell, Massachusetts 01854 (US); RAMANATH, Srinivasan, Holden, Massachusetts 01520 (US); VEDANTHAM, Ramanujam, Worcester, Massachusetts 01606 (US); UPADHYAY, Rachana, Shrewsbury, Massachusetts 01545 (US); REIS, Signo, Rolla, Missouri 65401 (US)
(74) Representative: Zimmermann & Partner Patentanwälte mbB
(86) International application number: PCT/US2012/072240
(87) International publication number: WO 2013/102174

(56) References cited:
- EP-A2- 1 598 147
- WO-A1-95/19871
- US-A- 4 951 427
- US-A1- 2003 205 003
- US-A1- 2003 205 003
- US-A1- 2004 185 763
- US-A1- 2009 313 906
- US-A1- 2011 143 641

## Description

### TECHNICAL FIELD

The following is directed to abrasive articles, and more particularly bonded abrasive articles having a particularly high amount of porosity.

### BACKGROUND ART

In the production of electronic devices, the back surface of a semiconductor wafer having a plurality of circuits such as IC's and LSI's is ground to a predetermined thickness by a grinding machine before it is divided into individual chips. To grind the back surface of the semiconductor wafer efficiently, a grinding machine equipped with a rough grinding unit and a finish grinding unit is generally used. Generally, the article utilized to conduct the rough grinding process is a bonded abrasive body or bond grindstone, which is obtained by bonding together diamond abrasive grains having a relatively large size with a vitrified bond or metal bond material. A resin bond grindstone having diamond abrasive grains of a median particle size of 2 microns or more contained in a resin bond is typically used for finish grinding operations. Smaller sizes of diamonds generally cannot be utilized in resin bonded articles.

In some cases, the content of the inorganic bonding agent is made relatively high for increasing a grade of the vitrified grindstone and also a degree of strength with which the inorganic bonding agent holds the abrasive grains together. However, such grindstones are not completely satisfactory, having reduced porosity, which can result in difficult or insufficient fracturing and removal of used abrasive grains, leading to relatively easy glazing or clogging of the surface of the vitrified grindstone, chipping of the abrasive structure, poor dressability of the grindstone, and other drawbacks.

The formation of high-porosity grindstones has been disclosed. Generally, high-porosity grindstone bodies are accomplished by the use of foaming agents during forming, which create bubbles and thus porosity in the finally-formed abrasive product.

Still, the industry continues to demand improved grindstone materials, capable of achieving improved grinding performance.

US 2003/0205003 discloses an abrasive tool having a modulus of rupture of at least 6,000 psi. The abrasive comprises at least 1%, by volume, microcrystalline alpha-alumina (MCA) abrasive grain, optionally secondary abrasive grain such as superabrasive grain, and 3 to 30%, by volume, of a vitrified bond. The vitrified bond comprises at least two immiscible phases during firing of the abrasive tool at about 700 to 1,100°C.

### SUMMARY OF INVENTION

Subject matter of the present invention is an abrasive article as defined in claim 1. The dependent claims relate to particular embodiments thereof. Further subject matter of the present invention is a method of forming an abrasive abrasive as defined in claim 9. The dependent claims relate to particular embodiments thereof.

According to a first aspect, an abrasive article comprises a bonded abrasive body including a bond material comprising a vitrified material, abrasive particles comprising a superabrasive material contained in the bond material, a porosity of at least about 50 vol% of the total volume of the bonded abrasive body, and wherein the bond material and the abrasive particles have a ΔCTE of not greater than about 5.5 ppm/°C, wherein ΔCTE is defined as a difference between a CTE of the bond material and a CTE of the abrasive particles.

According to a second aspect, a method of forming a bonded abrasive article according to the present invention comprises forming a green body comprising a bond material, abrasive particles comprising a superabrasive material, and converting at least a portion of the superabrasive material to a gaseous phase material and forming a bonded abrasive body without crystalline silicon carbide.

Further disclosed herein is an abrasive article which comprises a bonded abrasive body including a bond material comprising a vitrified material, abrasive particles comprising, a first type of superabrasive material having a first median particle size, and a second type of superabrasive material having a second median particle size different than the first median particle. The body also includes a porosity of at least about 50 vol% of the total volume of the bonded abrasive body.

Further disclosed herein is an abrasive article which comprises a bonded abrasive body including a bond material comprising not greater than about 14 mol% sodium oxide (Na2O) for the total mols of the bond material;, abrasive particles comprising a first type of superabrasive material having a first median particle size, and a second type of superabrasive material having a second median particle size different than the first median particle. The body also includes a porosity of at least about 50 vol% of the total volume of the bonded abrasive body.

Further disclosed herein is a method of forming a bonded abrasive article which method comprises forming a green body comprising, a bond material, abrasive particles comprising a first type of superabrasive material having a first median particle size, and a second type of superabrasive material having a second median particle size different than the first median particle, and converting at least a portion of the second type of superabrasive material to a gaseous phase material.

Further disclosed herein is a method of forming a bonded abrasive article which method comprises forming a green body comprising a bond material, abrasive particles comprising a first type of superabrasive material having a first median particle size, and a second type of superabrasive material having a second median particle size different than the first median particle size. The method further including converting at least a portion of the second type of superabrasive material to a gaseous phase material, and trapping at least a portion of the gaseous phase material within the bond material.

Further disclosed herein is a method of forming a bonded abrasive article which method comprises forming a green body comprising a bond material comprising an oxide, abrasive particles comprising a superabrasive material, a portion of the superabrasive material comprising diamond, and forming a bonded abrasive body from the green body including converting at least a portion of the diamond to a gaseous phase material, the gaseous phase material forming a portion of a porosity within the bonded abrasive body.

Further disclosed herein is an abrasive article which comprises a bonded abrasive body including a bond material comprising a vitrified material, abrasive particles comprising a second type of superabrasive material having a second median particle size of not greater than about 1 micron, wherein a portion of the second type of superabrasive material is oxidized, and a porosity of at least about 50 vol% of the total volume of the bonded abrasive body.

### BRIEF DESCRIPTION OF DRAWINGS

The present disclosure may be better understood, and its numerous features and advantages made apparent to those skilled in the art by referencing the accompanying drawings.
FIG. 1 includes a flow chart providing a method of forming a bonded abrasive body according to embodiment.
FIGS. 2A-2C include SEM images of a bonded abrasive body.

The use of the same reference symbols in different drawings indicates similar or identical items.

### DESCRIPTION OF EMBODIMENTS

The following includes a bonded abrasive article suitable for use in material removal applications. The bonded abrasive articles of the embodiments herein may be particularly suited for grinding hard materials used in fabricating sensitive electronic material, such as wafers or substrates. In particular instances, the abrasive articles may be in the form of a grindstone used for backgrinding operations of semiconducting wafer materials.

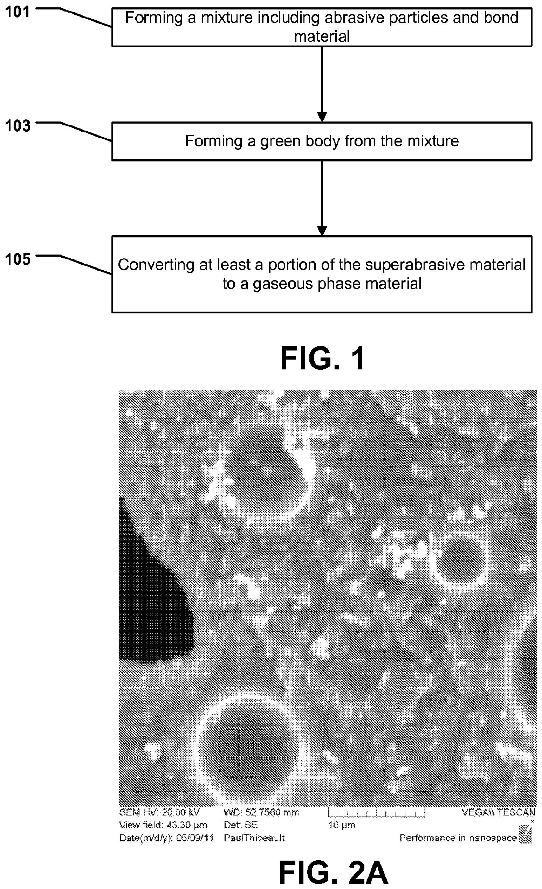

FIG. 1 includes a flow chart illustrating a method of forming a bonded abrasive article. As illustrated, the process can be initiated at step 101, by forming a mixture that includes a bond material and abrasive particles. The bond material is formed of an inorganic material, and more particularly is a frit material that forms a vitreous phase material upon suitable heat-treatment. For certain embodiments, the bond material can include an oxide, and more particularly a combination of oxide compounds. Certain suitable bond materials can be silica-based materials, wherein a majority content of the material can be formed of silica (SiO₂). Forming of the mixture may include a mixing process such that the components of the mixture are uniformly dispersed within each other.

The abrasive particles of the mixture include a superabrasive material. Suitable superabrasive materials can include cubic boron nitride (cBN), diamond and a combination thereof. In a particular embodiment, the superabrasive material can consist of essentially of diamond. The diamond may be natural or synthetic. The bonded abrasive body can be essentially free of silicon carbide.

For certain embodiments, the abrasive particles can include a first type of superabrasive material and a second type of superabrasive material. In some instances, the first type of superabrasive material and second type of superabrasive material may differ from each other based upon the median particle size of each of the types. For example, the first type of superabrasive material may have a first median particle size and the second type of superabrasive material may have a second median particle size that is different than the first median particle size. According to one example, the second median particle size [PS2] can be less than the first median particle size [PS1], and more particularly, at least about 1.1 times less than the first median particle size [PS1]. Stated alternatively, the first median particle size can be at least about 1.1 times greater than the second median particle size [PS2], such that [PS1]≥[PS2]*1.1. In other instances, the second median particle size can be at least about 1.3 times less than the first median particle size, such as at least about 1.3 times less, at least about 1.5 times less, at least about 2 times less, or even at least about 2.5 times less than the first median particle size. Still, in one particular example, the second median particle size can be not greater than about 10 times less than the first median particle size. It will be appreciated that the difference between the first median particle size and the second median particle size can be within a range between any of values provided above.

The first type of superabrasive material can have a first median particle size that is at least about 1 micron. In other instances, the first median particle size can be greater, such as at least about 1.5 microns, at least about 2 microns, or even at least about 2.5 microns. Still, the first median particle size may be not greater about 20 microns, such as not great than about 18 microns, or even not great than about 8 microns. It will be appreciated that the first median particle size can be within a range between any of the minimum and maximum values provided above.

The second type of superabrasive material can have a second median particle size that may be not greater than about 1 micron. Still, in other instances, the second median particle size may be smaller, such as not great than about 0.9 microns, not greater than about 0.8 microns, not greater than about 0.7 microns, or even not great than about 0.5. Still, the second median particle size may be at least about 0.01 microns, such as at least about 0.05 microns, at least about 0.08 microns, at least about 0.01 microns, or even at least about 0.2 microns. It will be appreciated that the second median particle size can be within a range between any of the minimum or maximum values provide above.

For certain abrasive articles, the first type of superabrasive material and second type of superabrasive material can have the same composition. For example, the first type of superabrasive material can consist essentially of diamond and a second type of superabrasive material can consist of essentially of diamond. Still, the second type of superabrasive material can have a different composition than the first type of superabrasive material.

The mixture can include various amounts of the first type of superabrasive material and the second type of superabrasive material. For example, in certain instances, the mixture can be formed to contain a greater content of the first type of superabrasive material than the second type of superabrasive materials. For example, the mixture can contain at least about 1.5 times greater content (wt%) of the first type of superabrasive material than the second type of superabrasive material. In yet another instance, the mixture can include at least about 1.8 times greater, such as at least about 2 times greater, at least about 2.5 times greater, at least about 3 times greater content (wt%) of the first type of the superabrasive material than the second type of the superabrasive material.

Alternatively, the mixture may contain a greater content of the second type of superabrasive material as compared to the first type of superabrasive material. For example, the mixture may be formed to include at least about 1.5 times greater content (wt%) of the second type of superabrasive material than the first type of superabrasive material. In yet another instance, the mixture can include at least about 1.8 times greater, such as at least about 2 times greater, at least about 2.5 times greater, at least about 3 times greater content (wt%) of the second type of the superabrasive material than the first type of the superabrasive material.

Forming the mixture may include the provision of other materials in addition to the bond material on abrasive particles. For example, other additives such as foaming agents, binders, grinding agents, and the like may be added to the mixture. In certain instances, the mixture may include a minority content of binder, which may include an organic material, such as polyethylene glycol (PEG). Such binders may facilitate formation of the mixture into a green body. Furthermore, other materials may be added in minority amounts, including for example foaming agents, such as sodium silicate (Na₂SiO₃) or grinding aids such as cerium oxide (CeO₂).

After forming the mixture at step 101, the process can continue at step 103, by forming a green body from the mixture. It will be appreciated that reference to a green body includes a body that is not finally-formed and may undergo further processes, such as through a firing process, such as a bisque firing or a sintering process to densify the material. In accordance with one embodiment, one suitable process of forming a green body can include a pressing operation. Certain suitable pressing operations can include cold pressing operations, and more particularly cold isostatic pressing operations. In accordance with an embodiment, the cold pressing operation can be conducted at approximately room temperature while applying a pressure to the mixture within a range of about 0.25 tons/in² (3.44 MPa) and about 10 tons/in² (137.90 MPa).

After forming a green body at step 103, the process can continue at step 105 by converting at least a portion of the superabrasive material to a gaseous phase material. The process of converting at least a portion of the superabrasive material to a gaseous phase material can include a firing process. Firing may include heating the green body to a particular firing temperature and holding the green body at the firing temperature to facilitate converting at least a portion of the superabrasive material to a gaseous phase material. In one example, the firing temperature can be at least about 200°C. In other examples, the firing temperature may be greater, such as at least about 300°C, at least about 400°C, or even at least about 500°C. Still, the firing temperature may be not greater than about 1000°C, such as not greater than about 900°C, not greater than about 800°C, not greater than about 850°C, or even not greater than about 800°C. It will be appreciated that the firing temperature can be within a range between any of the minimum or maximum temperatures provide above.

Furthermore, the firing process may be conducted for a particular duration at the firing temperature. For example, suitable durations can include a time of not greater than about 10 hours, such as not greater than about 8 hours, not greater than about 6 hours, or even not greater than about 5 hours. Still, the firing process may be conducted such that the duration at the firing temperature may at least about 10 minutes, such as at least about 30 minutes, at least about 1 hour, or even at least about 2 hours. It will be appreciated that the duration at the firing temperature can be within a range between any of the minimum or maximum times provide above.

Furthermore, the process of converting at least a portion of the superabrasive material to a gaseous phase material can include treating the green body, particularly heat-treating the green body in a particular atmosphere. For example, the green body may undergo firing in an oxidizing atmosphere. In more particular instances, the oxidizing atmosphere may be an oxygen-rich atmosphere. In accordance with one embodiment, the oxygen-rich atmosphere can contain at least 30 vol% oxygen for the total volume of the chamber during firing. It will be appreciated that the atmosphere can be an ambient atmosphere.

The bond material can have a particular softening point temperature, which may be defined as the temperature at which the bond material has a viscosity of between about 8-9 log10 (η, Pa·s) as measured via dilatometry. The glass transition temperature can be not greater than about 560°C. In other instances, the bond material may have a softening point temperature of not greater than about 550°C, such as not greater than about 540°C, or even not greater than about 530°C. Still, the softening point temperature of the bond material may be limited, such as that it can be at least about 200°C or even at least about 250°C. It will be appreciated that the glass transition temperature can be within a range between any of the minimum or maximum times provide above.

During the process of converting at least a portion of the superabrasive material to a gaseous phase material, the heat treating process may be conducted at a particular temperature relative to the softening point temperature. For example, converting may be conducted such that the firing temperature can be greater than the softening point temperature of the bond material. In certain instances, the difference between the firing temperature and the softening point temperature may be set in a particular manner, such that the difference between the firing temperature and softening point temperature can be not greater than 230°C. According to another process, the difference between the firing temperature and the softening point temperature of the bond can be not greater than about 220°C, not greater than about 200°C, not greater than about 195°C, not greater than about 190°C, or even not greater than about 185°C. Still, the difference between the firing temperature and the softening point temperature of the bond may be at least about 10°C, such as at least about 20°C, at least about 50°C, at least about 100°C, at least about 120°C, or even at least about 130°C. It will be appreciated that the difference between the firing temperature and the softening point temperature may be between a range between any of the minimum and maximum temperatures provided above.

For one embodiment, the process of converting at least a portion of the superabrasive material to a gaseous phase material can include converting a portion of a diamond material to a non-diamond carbon-phase material. Suitable examples of a non-diamond carbon-phase material can include graphite.

In particular instances, the process of converting can include reducing the volume percent of abrasive particles comprising the superabrasive material within the green body by changing a portion of the superabrasive material to a gaseous phase material. In more particular instances, diamond material can be oxidized thus forming a gaseous phase material comprising oxygen, carbon, and a combination thereof. For example, the diamond can be oxidized to produce a gaseous phase material of carbon dioxide, carbon monoxide, and a combination thereof.

In particular instance, the process of converting at least a portion of the superabrasive material to a gaseous phase material can include a trapping process, wherein a portion of the gaseous phase material created from the superabrasive material can be trapped within the bond material of the green body. The trapped gaseous phase material within the green body can form pores in the body. Notably, the process of converting, and more particularly the process of trapping the gaseous phase material can be facilitated by conducting the converting process while a least a portion of the bond material is in a fluid state. Conducting the converting process while at least a portion of the bond material is in a fluid (e.g., liquid or low viscosity) state can facilitate capture of the gaseous phase material as bubbles within the fluid portion of the bond material, thus facilitating the formation of porosity within the bonded abrasive body. As such, the firing process can be conducted at a suitable temperature to convert at least a portion of the bond material into a liquid state while converting a portion of the superabrasive material to the gaseous phase material.

The process of converting can include converting a portion of the second type of superabrasive material. In particular instances, wherein the abrasive particles comprise a first type of superabrasive material and a second type of superabrasive material, the second type of superabrasive material may be preferentially oxidized over the first type of the superabrasive material. That is, for example the second type of superabrasive material having a second median particle size smaller than the first median particle size, may preferentially oxidized before the first type of superabrasive material. Thus a greater content of the second type of superabrasive material may be converted to a gaseous phase material during processing than the first type of superabrasive material.

After completing the converting process, the body may be cooled from the firing temperature to facilitate the formation of the finally-formed bonded abrasive body. It will be appreciated that further machining operations may be conducted. For example, in fact a large blank of bonded abrasive material may be formed according to the embodiment herein, which may be in the form of a brick or puck. The blank can be further processed, such as through a cutting process to extract bonded abrasive bodies of suitable dimensions.

In accordance with the invention, the bonded abrasive body has a significant amount of porosity, i.e. at least about 50 vol% of the total volume of the bonded abrasive body including the volume of solid material and pore volume as measured by the Archimedes process. According to embodiments, the amount of porosity can be greater such as at least about 54 vol%, at least about 56 vol%, or even at least about 58 vol%. Still, the amount of porosity may be not greater than about 85 vol%, such as about not greater than 82 vol%, or even not greater than about 80 vol% for the total volume of the total volume of the bonded abrasive body. It will be appreciated that the amount of porosity within the bonded abrasive body may be between a range between any of the minimum and maximum temperatures provided above.

Furthermore, the bonded abrasive body may have a particular content of abrasive particles. For example, the bonded abrasive body may contain at least about 5 vol%, abrasive particle for the total volume of solid components in the bonded abrasive body and excluding the volume of porosity in the body. In other instances, the amount of the abrasive particles within the bonded abrasive body can be greater, such as at least about 10 vol%, at least about 14 vol%, at least about 16 vol% or even at least about 17 vol% for the total volume of solid components of the bonded abrasive body. Still, the total amount of abrasives particles within the bonded abrasive material can be not greater than about 35 vol%, such as about not greater than 30 vol%, not greater than about 30 vol%, not greater than about 26 vol%, or even not greater than about 23 vol% for the total volume of solid components in the bonded abrasive body. It will be appreciated that the total amount of abrasive particles within the bonded abrasive body can be within a range between any of the minimum and maximum percentages provided above.

Furthermore, the bonded abrasive body can contain a particular amount of bond material. For example, the body can contain about 50 vol% bond material for the total volume of solid component in a bonded abrasive body excluding the content of pore volume of the body. In other instances, the bonded abrasive body can contain a higher content of bond material such as at least about 55 vol%, such as at least 60 vol%, at least about 63 vol%, at least about 66 vol% or even at least about 75 vol%. Still, the amount of bond material within the body can be not greater than about 90 vol%, such as not greater than about 86 vol%, such as not greater than 82 vol%, not greater than about 78 vol%, or even not greater than about 74 vol%. It will be appreciated that the amount of bond material within the body can be between a range between any of the minimum and maximum percentages provided above.

The bonded abrasive body may contain a certain content of filler material. Certain suitable fillers can include compounds having elements such as sodium, cerium, and a combination thereof. In a particular example, the boded abrasive body can have a content of cerium oxide (CeO₂) of at least about 0.4 vol% for the total volume of solid components in the bonded abrasive body excluding the volume of porosity. In other examples the content of cerium oxide may be greater, such that it is at least about 0.8 vol% or even at least about 1 vol%. Still, the content of cerium oxide within the body can be limited, such that it may be not greater than about 6 vol% or not greater 4 vol%. It will be appreciated that the amount of cerium oxide within the body can be within a range within any of the minimum and maximum percentages noted above.

The bonded abrasive body may further contain specific content of sodium silicate (Na₂SiO₃). For example, the bonded abrasive body can contain at least about 1 vol% sodium silicate for the total volume of solid components of the bonded abrasive body. In another example, the amount of sodium silicate within the bonded abrasive body may be greater, such as at least about 2 vol%, at least about 3 vol% at least about 4 vol%, or even at least about 5 vol%. Still, the amount of sodium silicate within the bonded abrasive body may be not greater than about 12 vol%, such as not greater than 10 vol%, or even not greater than 9 vol%. It will be appreciated that the bonded abrasive body may contain a content of sodium silicate within a range between any of the minimum and maximum percentages noted above.

Additionally, in specific instances the bonded abrasive body may be formed such that it contains limited amounts of free metal elements. For example the bottom abrasive body may contain not greater than about 1 wt% free metal elements for the total weight of the body. In other instances, the content of free metal elements may be less, such as not greater than about 0.5 wt%, not greater than about 0.1 wt%, or even not greater than about 0.05 wt%. In specific instances, the bonded abrasive body may be essentially free of free metal elements. Such compositions may facilitate use of the bonded abrasive body in grinding of sensitive electronic component.

The bond material has a specific composition facilitating the formation of the bonded abrasive body in accordance with the processes described herein. For example, the bond material is a vitreous phase material, notably an oxide material. More particularly, the bond material may be a silica-based material that comprises at least about 50 mol% (SiO₂) for the total content of moles in the bond material. In other instances, the content of silica can be greater, such as at least about 52 mol%, or even least about 54 mol% silica. Still, the amount of silica within the bond material can be not greater than about 70 mol%, or even not greater than about 65 mol%. It will be appreciated that the content of silica within the bond material can be within a range between any of them minimum and maximum percentages noted above.

Additionally, the bond material may contain a specific content of alumina (Al₂O₃). For example, the bond material may contain not greater than about 4 mol% alumina for the total content of moles in the bond material. In other instances, the amount of alumina may be less, such as not greater than about 3 mol% for the total moles of bond material. In one example, the amount of aluminum may be at least about 0.5 mol% such as at least about 1 mol%. It will be appreciated that the amount of alumina within the bond material may be within a range within any of the minimum and maximum percentages noted above.

Furthermore, the bond material may include a specific content of boron oxide (B₂O₃). For example, the bond material may contain at least about 16 mol% boron oxide for the total content of moles in the bond material. In other instances, the amount of boron oxide may be greater, such as at least about 17 mol%, or even about 20 mol%. Still, the amount of boron oxide within the bond material may be not greater than 30 mol% or even not greater than 26 mol%. It will be appreciated that the bond material may contain a content of boron oxide within a range between any of the minimum and maximum percentages noted above.

The bond material may contain a specific amount of calcium oxide (CaO). For example, the bond material may contain not greater than about 9 mol%, such as not greater than about 8 mol%, not greater than 7 mol%, or even not greater than about 3 mol% calcium oxide for the total content of moles in the bond material. In at least one example, the amount of calcium oxide within the bond material can be at least 0.5 mol% or even 1 mol%. It will be appreciated that the amount of calcium oxide within the bond material can be within a range between any of the minimum and maximum percentages noted above.

The bond material may include a particular content of barium oxide (BaO). For example, the bond material may be formed to have at least about 0.2 mol%, such as at least about 0.5 mol%, or even at least 1 mol% barium oxide for the total content of moles in the bond material. However, in one example, the amount of barium oxide may not greater than 6 mol% or even not greater than about 4 mol%. It will be appreciated that the bond material may contain an amount of barium oxide within a range between any of the minimum and maximum percentages noted above.

According to another example, the bond material may be formed to have a particular content of potassium oxide (K₂O). For example, the bond material can include at least 2 mol% potassium oxide or even at least about 2.5 mol% for the total content of moles in the bond material. According to one example, the amount of potassium oxide within the bond material may be not greater than about 8 mol%, such as not greater than about 6 mol%. It will be appreciated that the amount potassium oxide within the bond material may be within a range between any of the minimum and maximum percentages noted above.

Bond material may be formed to have a specific content of lithium oxide (Li₂O). For example, the bond material may contain at least about 0.5 mol% lithium oxide. In other instances the amount of lithium oxide may be at least about 0.8 mol% or even at least about 1mol% for the total moles of bond materials. In one particular example, the bond may contain no greater than about 9 mol%, such as not greater than 7 mol% lithium oxide. It will be appreciated that the amount of lithium oxide within the bond material can be within a range any of the minimum and maximum percentages noted above.

The bond material may be formed to have a particular content of sodium oxide (Na₂O). For example, the bond material can contain not greater than about 14 mol%, such as not greater than about 12 mol%, not greater than about 10 mol%, not greater than about 8 mol% or even not greater than about 6mol% sodium oxide for the total content of moles in the bond material. However, in another example, the bond material may contain at least 0.5 mol%, such as at least about 1 mol%, or even at least about 3 mol% sodium oxide for the total content of moles in the bond material. It will be appreciated that the bond material can contain an amount of sodium oxide within a range between any of the minimum and maximum percentages noted above.

The bond material may contain a specific content of zinc oxide (ZnO). For example, the content of zinc oxide within the bond material may be at least 0.5 mol% for the total content of moles in the bond material. In another example, the bond material can contain at least about 0.8 mol% or even about 1 mol%. According to an example, the amount of the zinc oxide within the bond material may be not greater than about 5 mol% or even not greater than about 4 mol%. It will be appreciated that the amount of zinc oxide within the bond material may be within a range between any of the minimum and maximum percentages noted above.

In specific instances, the bond material may be formed to have a particular linear coefficient of thermal expansion (CTE) to facilitate the formation of a bonded abrasive body having the features described herein. For example, the bond material can have a linear coefficient with thermal expansion as measured at 300°C of not greater than about 9 ppm/°C. In other examples, the coefficient of thermal expansion of the bond material may be less, such as not greater about 8.5 ppm/°C, not greater than about 8 ppm/°C, not greater than 7.8 ppm/°C, or even not greater than about 7.6 ppm/°C. Still, in one example, the coefficient of thermal expansion of the bond material may be at least about 2 ppm/°C, such as at least about 3 ppm/°C, or even at least about 4 ppm/°C. It will be appreciated that the coefficient of thermal expansion within the bond material may be within a range between any of the minimum and maximum values noted above.

According to the present invention, the bonded abrasive body is formed such that the bond material and abrasive particles have a specific difference in coefficient of thermal expansion (ΔCTE). The specific difference in CTE may facilitate formation of the bonded abrasive body having the features describes herein. According to the invention, the difference in CTE between the bond material and abrasive particles is not greater than about 5.5 ppm/°C. In other instances, the difference in CTE may be not greater than about 5 ppm/°C, such as about not greater than 4.5 ppm/°C, not greater than about 4 ppm/°C, not greater than 3.8 ppm/°C, or even not greater than about 3.6 ppm/°C. However, according to one example, the difference in CTE between the bond material and the abrasive particles may be at least about 0.2 ppm/°C or even at least about 0.5 ppm/°C. It will be appreciated that the difference in coefficient of thermal expansion between the bond material and the abrasive particles may be within a range between any of the minimum and maximum values noted above.

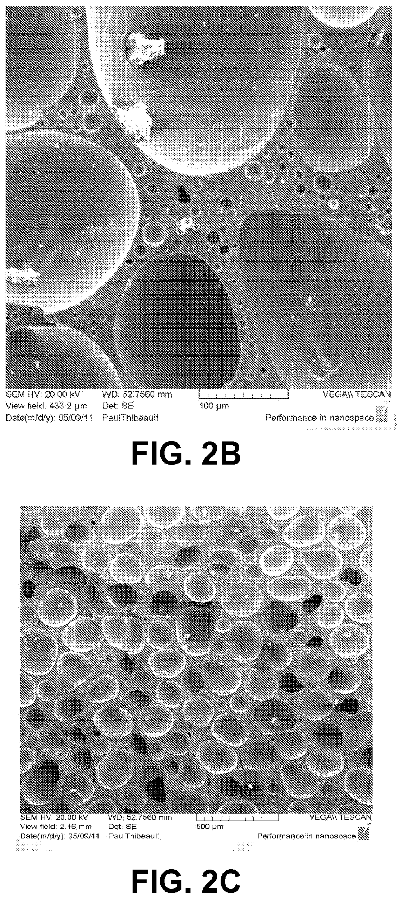

FIGS. 2A-2C include SEM photos of a bonded abrasive body. For example, FIG.2A includes a SEM image of a surface of a bonded abrasive body. As illustrated, the bonded abrasive body can include a bond material 201 and pores 203 contained within the bond material. The pores of the bonded abrasive body can be substantially spherical, and more particularly, a majority of the pores can have an elliptical or circular shape as viewed in cross-section as provided in FIG. 2A. Moreover, a majority content of pores has smooth, arcuate surfaces as viewed in cross-section. FIG. 2B includes a SEM image of a portion bonded abrasive body. As provided in the image of FIG. 2B, the bonded abrasive body can have a variety of various pore sizes including large pores 205 separated by bond post 207 extending between the large pores 205. Furthermore, the bonded abrasive body can include smaller pores 209 disposed in the bond material, in particularly the bond post between the large pores 205. The bonded abrasive body can have a multimodal pore size distribution. For example, the body can have a bimodal pore size distribution comprising a non-Gaussian distribution of pore sizes, such that a plot of average pore size versus frequency demonstrates a first mode defining large pores 205 having an average pore size greater than a second mode defining fine pores 209 having an average pore size less than the average pore size of the large pores 205. As illustrated, the fine pores 209 may have an average pore size that is at least 2 times smaller than the average pore size of the large pore 205.

FIG.2C includes a SEM image of a portion of a bonded abrasive body. FIG. 2C further illustrates the distinction between the large pores 205 and the small pores 209 making up the bonded abrasive body. Furthermore, FIG. 2C illustrates the general morphology of the large pores 205, notably each of the large pores having a generally spherical three dimensional shape, and a circular or elliptical two dimensional shape as viewed in cross-section.

With regard to those embodiments incorporating a second type of superabrasive material that may be oxidized during a process of converting, such oxidation may create a non-diamond carbon-phase material, such as graphite. In particular instances, the bonded abrasive body may contain a specific content of the non-diamond carbon-phase material that can be contained in the bond material. Additionally or alternatively, the non-diamond carbon-phase material may be disposed at an exterior surface of at least a portion of the second type of superabrasive material.

In certain instances, the bonded abrasive body can include pores that may contain some of the gaseous phase material formed during the process of converting. As such, the pores within the bonded abrasive body may contain one or more compositions comprising carbon, oxygen, and a combination thereof. In fact, in one particular embodiment, a portion of the pores of the bonded abrasive body may contain a gaseous phase material of carbon dioxide, carbon monoxide, or a combination thereof.

According to the present invention, the method of forming a bonded abrasive article comprises forming a green body comprising a bond material, abrasive particles comprising a superabrasive material, and converting at least a portion of the superabrasive material to a gaseous phase material and forming a bonded abrasive body without crystalline silicon carbide.

Embodiments of the superabrasive material may comprise diamond. For example, the superabrasive material can be diamond, or the superabrasive material may consist essentially of diamond. The superabrasive material may not include silicon carbide, or be essentially or substantially free of crystalline silicon carbide. The superabrasive material may contain diamond and only an amorphous (i.e., non-crystalline) form of silicon carbide.

Other examplesof an abrasive article may comprise a bonded abrasive body without crystalline silicon carbide and include a bond material comprising a vitrified material, and abrasive particles comprising: a first type of superabrasive material having a first median particle size; a second type of superabrasive material having a second median particle size different than the first median particle; and a porosity of at least about 50 vol% of the total volume of the bonded abrasive body.

Some examplesof a method of forming a bonded abrasive article may comprise forming a green body comprising a bond material and abrasive particles comprising: a first type of superabrasive material having a first median particle size; a second type of superabrasive material having a second median particle size different than the first median particle; and converting at least a portion of the second type of superabrasive material to a gaseous phase material without forming crystalline silicon carbide.

In other examples, a method of forming a bonded abrasive article may comprise forming a green body comprising a bond material; abrasive particles comprising: a first type of superabrasive material having a first median particle size; a second type of superabrasive material having a second median particle size different than the first median particle size; converting at least a portion of the second type of superabrasive material to a gaseous phase material without forming (or be substantially or essentially free of) crystalline silicon carbide; and trapping at least a portion of the gaseous phase material within the bond material.

### Examples

### Example 1

A sample according to the invention is made by mixing 25 wt% diamond particles with a median particle size of 0.5-1 microns with 75 wt% of a frit material having the composition provided in Table 1. The mixture is suitably mixed and sieved through a 165 mesh screen. 16 wt% binder of a 97% solution of polyethylene glycol (PEG). The mixture is blended again and sieved through a 20 mesh. The mixture is dried for approximately 16 hours and then cold pressed at 13.79 MPa (1 ton/square inch) for 10 seconds at room temperature to form a green body. The green body is then fired through a firing cycle including heating at 550°C for 1 hour and then 690°C for approximately 4 hours to complete a converting process and form a bonded abrasive blank. Bonded abrasive bodies are then extracted from the bonded abrasive blank via a water jet cutting operation.

The bonded abrasive body of sample S1 has about 72 vol% bond, 19 vol% abrasive particles, 2 vol% of CeO₂, and 7 vol% Na₂SiO₃ for the total volume of the solid components. The bonded abrasive body also includes approximately 70-85 vol% porosity for the total volume of the body.

**Table 1: Bond Composition of Sample 1**

| Material | Mol% |
|---|---|
| Al2O3 | 1.69 |
| B2O3 | 20.57 |
| BaO | 1.17 |
| CaO | 1.94 |
| Fe2O3 | 0.01 |
| K2O | 3.6 |
| Li2O | 5.56 |
| MgO | 0.05 |
| Na2O | 4.85 |
| SiO2 | 58.31 |
| ZnO | 2.2 |
| ZrO2 | 0.05 |

CS1 is a comparative grindstone utilized in backgrinding operations on semiconductor wafers, commercially available as from Saint-Gobain Abrasives, Inc. The CS1 body includes 19 vol% diamond having a median particle size of 0.5-1 microns, 78 vol% bond material, 2 vol% CeO2, 1 vol% SiC, 0 vol% Na₂SiO₃, and about 72-74 vol% porosity.

CS2 is a comparative grindstone utilized in backgrinding operations on semiconductor wafers, commercially available as Poligrind from Disco Corporation. The CS2 body includes 25 wt% diamond having a median particle size of 2 microns, 25 wt% bond material, 25 wt% Na₂SiO₃, 25 wt% Polystryrene particles, and 75-90 vol% porosity. The bond material of sample CS2 was measured via ICP and is provided in Table 2 below.

**Table 2**

| Material | Mol% |
|---|---|
| Al2O3 | 4.87 |
| B2O3 | 19.79 |
| BaO | 0 |
| CaO | 9.5 |
| Fe2O3 | 0 |
| K2O | 1.92 |
| Li2O | 0 |
| MgO | 0.31 |
| Na2O | 15.77 |
| SiO2 | 47.63 |
| ZnO | 0 |
| ZrO2 | 0 |

Samples S1 and CS2 are used in a backgrinding process to measure the wear. The backgrinding operation is conducted using a load of approximately 45N, grinding time of 15 sec, a spindle speed of 150 rpm, on a workpiece of 100 grit sandpaper. The wear of sample S1 is approximately equivalent to the wear of sample CS2. Without wishing to be tied to a particular theory, it is thought that the use of particular combination of components facilitates improved wear of the bonded abrasive body over state of the art grindstone articles.

### Example 2

Sample CS3 is a comparative grindstone utilized in backgrinding operations on semiconductor wafers, commercially available as from Saint-Gobain Abrasives, Inc., as Supernano. The CS3 body includes 19 vol% diamond having a median particle size of 0.72 microns (d50) and 0.15 microns (SD), 78 vol% bond material, 2 vol% CeO2, 1 vol% SiC, and about 68-72 vol% porosity.

During its manufacture, CS3 contained about 1wt% to 2wt% SiC that was converted to a gaseous phase. However, CS3 retains a residual amount of crystalline silicon carbide that remains in the final product. In contrast, sample S1 had no detectable crystalline silicon carbide.

The foregoing disclosure is directed to abrasive products, and particularly bonded abrasive products, which represent a departure from the state-of-the-art. The bonded abrasive products of the present invention utilize a combination of features that facilitate improved grinding performance. As described in the present application, the bonded abrasive bodies utilize a particular amount and type of abrasive particles, particular amount and type of bond material, a particular amount and type of porosity, and other additives. Moreover, it was discovered that the bonded abrasive articles are capable of having marked differences in certain mechanical characteristics versus some state-of-the-art conventional articles, including for example wear.

In the foregoing, reference to specific embodiments and the connections of certain components is illustrative. It will be appreciated that reference to components as being coupled or connected is intended to disclose either direct connection between said components or indirect connection through one or more intervening components as will be appreciated to carry out the methods as discussed herein. As such, the above-disclosed subject matter is to be considered illustrative, and not restrictive. Thus, to the maximum extent allowed by law, the scope of the present invention is to be determined by the following claims, and shall not be restricted or limited by the foregoing detailed description.

## Claims

1. An abrasive article comprising:
a bonded abrasive body including:
a bond material comprising a vitrified material; the bonded abrasive body further includes abrasive particles comprising a superabrasive material contained in the bond material;
a porosity of at least 50 vol% of the total volume of the bonded abrasive body; and **characterised in that** the bond material and the abrasive particles have a difference in coefficient of thermal expansion (ΔCTE) of not greater than 5.5 ppm/°C, wherein ΔCTE is defined as a difference between a coefficient of thermal expansion (CTE) of the bond material and a CTE of the abrasive particles.

2. The abrasive article of claim 1, wherein the bond material comprises at least 50 mol% silica (SiO₂), and not greater than 70 mol% silica.

3. The abrasive article of claim 1 or 2, wherein the bonded abrasive body comprises a filler, wherein the filler comprises a compound including an element selected from the group consisting of sodium (Na), cerium (Ce), and a combination thereof.

4. The abrasive article of any one of the preceding claims, wherein the bonded abrasive body comprises sodium (Na), wherein the bonded abrasive body comprises sodium silicate (Na₂SiO₃), wherein the bonded abrasive body comprises at least 1 vol% and not greater than 12 vol% sodium silicate for the total volume of solid components in the bonded abrasive body.

5. The abrasive article of any one of the preceding claims, wherein the bonded abrasive body comprises a bonded abrasive disk configured for grinding of semiconductor wafers.

6. The abrasive article of any one of the preceding claims, wherein the bonded abrasive body comprises not greater than 1 wt% of free metal elements, wherein the bonded abrasive body is essentially free of free metal elements.

7. The abrasive article of any one of the preceding claims, wherein the bonded abrasive body is essentially free of silicon carbide.

8. The abrasive article of any one of the preceding claims, wherein the abrasive particles consist essentially of diamond.

9. A method of forming an abrasive article of any one of the preceding claims, comprising:
forming a green body comprising:
a bond material;
abrasive particles comprising a superabrasive material, where the bond material and the abrasive particles have a difference in coefficient of thermal expansion (ACTE) of not greater than 5.5 ppm/°C, wherein ACTE is defined as a difference between a coefficient of thermal expansion (CTE) of the bond material and a CTE of the abrasive particles; and
converting at least a portion of the superabrasive material to a gaseous phase material and forming a bonded abrasive body that is essentially free of crystalline silicon carbide.

10. The method of claim 9, further comprising forming a mixture of the bond material and the abrasive particles prior to forming the green body.

11. The method of claim 9 or 10, wherein the abrasive particles comprise a first type of superabrasive material and a second type of superabrasive material and converting includes converting a portion of the second type of superabrasive material.

12. The method of any one of claims 9 to 11, wherein converting includes heat treating, wherein converting includes firing the green body in an oxidizing atmosphere, wherein the oxidizing atmosphere optionally includes an oxygen-rich atmosphere of at least 30 vol% oxygen.

13. The method of claim 12, wherein firing is conducted at a temperature that is different than the softening point temperature by not greater than 230°C, and at least 10°C.

14. The method of any one of claims 9 to 13, wherein the abrasive particles comprise a first type of superabrasive material and a second type of superabrasive material and converting includes oxidizing a portion of the second type of superabrasive material to form a gaseous phase material comprising an oxide, wherein converting includes preferentially oxidizing the second type of superabrasive material before the first type of superabrasive material, wherein the gaseous phase material comprises carbon, wherein the gaseous phase material comprises one of carbon dioxide and carbon monoxide.

15. The method of any one of claims 9 to 14, wherein forming the green body includes a pressing the mixture to form a green body, wherein pressing includes a cold pressing operation, wherein pressing includes cold isostatic pressing, wherein the cold isostatic pressing is conducted at a pressure of at least 3.44 MPa (0.25 tons/in²), and not greater than 137.90 MPa (10 tons/in²).

## Patentansprüche

1. Schleifkörper, der Folgendes umfasst:
einen geklebten Schleifkörper, der Folgendes umfasst:
ein Klebematerial, das ein verglastes Material umfasst;
wobei der geklebte Schleifkörper ferner Schleifpartikel umfasst, die ein superabrasives Material umfassen, das in dem Klebematerial enthalten ist;
eine Porosität von mindestens 50 % des Gesamtvolumens des geklebten Schleifkörpers aufweist; und **dadurch gekennzeichnet,**
**dass** das Klebematerial und die Schleifpartikel einen Unterschied im Koeffizienten der Wärmeausdehnung (ΔCTE) aufweisen, der nicht größer ist als 5,5 ppm/°C, wobei ΔCTE als Unterschied zwischen einem Koeffizienten der Wärmeausdehnung (CTE) des Klebematerials und einem CTE der Schleifpartikel definiert ist.

2. Schleifkörper nach Anspruch 1, wobei das Klebematerial mindestens 50 mol-% Kieselsäure (SiO₂) und nicht mehr als 70 mol-% Kieselsäure umfasst.

3. Schleifkörper nach Anspruch 1 oder 2, wobei der geklebte Schleifkörper ein Füllmaterial umfasst, wobei das Füllmaterial eine Verbindung umfasst, die ein Element einschließt, das ausgewählt ist aus der Gruppe, die aus Natrium (Na), Cerium (Ce) und einer Kombination davon besteht.

4. Schleifkörper nach einem der vorhergehenden Ansprüche, wobei der geklebte Schleifkörper Natrium (Na) umfasst, wobei der geklebte Schleifkörper Natriumsilikat (Na₂SiO₃) umfasst, wobei der geklebte Schleifkörper mindestens 1 Vol.-% und nicht mehr als 12 Vol.-% Natriumsilikat am Gesamtvolumen der Feststoffkomponenten des geklebten Schleifkörpers umfasst.

5. Schleifkörper nach einem der vorhergehenden Ansprüche, wobei der geklebte Schleifkörper eine geklebte Schleifscheibe umfasst, die zum Schleifen von Halbleiterwafern ausgestaltet ist.

6. Schleifkörper nach einem der vorhergehenden Ansprüche, wobei der geklebte Schleifkörper nicht mehr als 1 Gew.-% freier Metallelemente umfasst, wobei der geklebte Schleifkörper im Wesentlichen frei von freien Metallelementen ist.

7. Schleifkörper nach einem der vorhergehenden Ansprüche, wobei der geklebte Schleifkörper im Wesentlichen frei von Siliziumkarbid ist.

8. Schleifkörper nach einem der vorhergehenden Ansprüche, wobei die Schleifpartikel im Wesentlichen aus Diamant bestehen.

9. Verfahren zum Ausbilden eines Schleifkörpers nach einem der vorhergehenden Ansprüche, das Folgendes umfasst:
Ausbilden eines Grünkörpers, der Folgendes umfasst:
ein Klebematerial;
Schleifpartikel, die ein superabrasives Material umfassen, wobei das Klebematerial und das abrasive Material einen Unterschied im Koeffizienten der Wärmeausdehnung (ACTE) aufweisen, der nicht größer als 5,5ppm/°C ist, wobei ACTE als ein Unterschied zwischen einen Koeffizienten der Wärmeausdehnung (CTE) des Klebematerials und einem CTE der Schleifpartikel definiert ist;
und
Umwandeln zumindest eines Teils des superabrasiven Materials in ein gasförmiges Material und Ausbilden eines geklebten Schleifkörpers, der im Wesentlichen frei ist von kristallinem Siliziumkarbid.

10. Verfahren nach Anspruch 9, das ferner eine Mischung aus Klebematerial und den Schleifpartikeln vor dem Ausbilden des Grünkörpers umfasst.

11. Verfahren nach Anspruch 9 oder 10, wobei die Schleifpartikel einen ersten Typ superabrasiven Materials und einen zweiten Typ superabrasiven Materials umfassen und wobei das Umwandeln das Umwandeln eines Teils des zweiten Typs superabrasiven Materials einschließt.

12. Verfahren nach einem der Ansprüche 9 bis 11, wobei das Umwandeln Wärmebehandlung einschließt, wobei das Umwandeln Brennen des Grünkörpers in einer oxidierenden Atmosphäre einschließt, wobei die oxidierende Atmosphäre optional eine sauerstoffreiche Atmosphäre von mindestens 30 Vol.-% Sauerstoff einschließt.

13. Verfahren nach Anspruch 12, wobei das Brennen wird bei einer Temperatur durchgeführt, die sich von der Erweichungspunkttemperatur um nicht mehr als 230 °C und mindestens 10 °C unterscheidet.

14. Verfahren nach einem der Ansprüche 9 bis 13, wobei die Schleifpartikel einen ersten Typ superabrasiven Materials und einen zweiten Typ superabrasiven Materials umfassen und das Umwandeln das Oxidieren eines Teils des zweiten Typs superabrasiven Materials einschließt, um ein gasförmiges Material auszubilden, das ein Oxid umfasst, wobei das Umwandeln vorzugsweise Oxidieren des zweiten Typs superabrasiven Materials vor dem ersten Typ superabrasiven Materials einschließt, wobei das gasförmige Material Kohlenstoff umfasst, wobei das gasförmige Material eines von Kohlendioxid und Kohlenmonoxid umfasst.

15. Verfahren nach einem der Ansprüche 9 bis 14, wobei das Ausbilden des Grünkörpers ein Pressen der Mischung zum Ausformen eines Grünkörpers einschließt, wobei das Pressen einen Kaltpressvorgang einschließt, wobei das Pressen kalt-isostatisches Pressen einschließt, wobei das kalt-isostatische Pressen bei einem Druck von mindestens 3,44 MPa (0,25 Tonnen/in²) und nicht höher als 137,90 MPa (10 Tonnen/in²) durchgeführt wird.

## Revendications

1. Article abrasif comprenant :
un corps abrasif lié comportant :
un matériau de liaison comprenant un matériau vitrifié ;
le corps abrasif lié comporte en outre des particules abrasives comprenant un matériau superabrasif contenu dans le matériau de liaison ;
une porosité d'au moins 50 % en volume du volume total du corps abrasif lié ; et **caractérisé en ce que** le matériau de liaison et les particules abrasives ont une différence de coefficient de dilatation thermique (ΔCTE) d'au plus 5,5 ppm/°C,
ΔCTE étant défini comme une différence entre un coefficient de dilatation thermique (CTE) du matériau de liaison et un CTE des particules abrasives.

2. Article abrasif selon la revendication 1, dans lequel le matériau de liaison comprend au moins 50 % en moles de silice (SiO₂), et au plus 70 % en moles de silice.

3. Article abrasif selon la revendication 1 ou 2, dans lequel le corps abrasif lié comprend une charge, la charge comprenant un composé comportant un élément choisi dans le groupe constitué de sodium (Na), de cérium (Ce) et d'une combinaison de ces derniers.

4. Article abrasif selon l'une quelconque des revendications précédentes, dans lequel le corps abrasif lié comprend du sodium (Na), le corps abrasif lié comprenant du silicate de sodium (Na₂SiO₃), le corps abrasif lié comprenant au moins 1 % en volume et au plus 12 % en volume de silicate de sodium pour le volume total de composants solides dans le corps abrasif lié.

5. Article abrasif selon l'une quelconque des revendications précédentes, dans lequel le corps abrasif lié comprend un disque abrasif lié configuré pour meuler des tranches de semiconducteur.

6. Article abrasif selon l'une quelconque des revendications précédentes, dans lequel le corps abrasif lié comprend au plus 1 % en poids d'éléments métalliques libres, le corps abrasif lié étant sensiblement exempt d'éléments métalliques libres.

7. Article abrasif selon l'une quelconque des revendications précédentes, dans lequel le corps abrasif lié est sensiblement exempt de carbure de silicium.

8. Article abrasif selon l'une quelconque des revendications précédentes, dans lequel les particules abrasives sont sensiblement constituées de diamant.

9. Procédé de formation d'un article abrasif selon l'une quelconque des revendications précédentes, comprenant :
la formation d'un corps vert comprenant :
un matériau de liaison ;
des particules abrasives comprenant un matériau superabrasif, où le matériau de liaison et les particules abrasives ont une différence de coefficient de dilatation thermique (ACTE) d'au plus 5,5 ppm/°C, ACTE étant défini comme une différence entre un coefficient de dilatation thermique (CTE) du matériau de liaison et un CTE des particules abrasives ; et
la conversion d'au moins une partie du matériau superabrasif en un matériau en phase gazeuse et la formation d'un corps abrasif lié qui est sensiblement exempt de carbure de silicium cristallin.

10. Procédé selon la revendication 9, comprenant en outre la formation d'un mélange du matériau de liaison et des particules abrasives avant la formation du corps vert.

11. Procédé selon la revendication 9 ou 10, dans lequel les particules abrasives comprennent un premier type de matériau superabrasif et un second type de matériau superabrasif et la conversion comporte la conversion d'une partie du second type de matériau superabrasif.

12. Procédé selon l'une quelconque des revendications 9 à 11, dans lequel la conversion comporte un traitement thermique, la conversion comportant la cuisson du corps vert dans une atmosphère oxydante, l'atmosphère oxydante comportant éventuellement une atmosphère riche en oxygène d'au moins 30 % en volume d'oxygène.

13. Procédé selon la revendication 12, dans lequel la cuisson est réalisée à une température qui est différente de la température du point de ramollissement d'au plus 230 °C, et d'au moins 10 °C.

14. Procédé selon l'une quelconque des revendications 9 à 13, dans lequel les particules abrasives comprennent un premier type de matériau superabrasif et un second type de matériau superabrasif et la conversion comporte l'oxydation d'une partie du second type de matériau superabrasif pour former un matériau en phase gazeuse comprenant un oxyde, la conversion comportant de préférence l'oxydation du second type de matériau superabrasif avant le premier type de matériau superabrasif, le matériau en phase gazeuse comprenant du carbone, le matériau en phase gazeuse comprenant l'un parmi le dioxyde de carbone et le monoxyde de carbone.

15. Procédé selon l'une quelconque des revendications 9 à 14, dans lequel la formation du corps vert comporte un pressage du mélange pour former un corps vert, le pressage comportant une opération de pressage à froid, le pressage comportant un pressage isostatique à froid, le pressage isostatique à froid étant réalisé à une pression d'au moins 3,44 MPa (0,25 tonne/po²), et d'au plus 137,90 MPa (10 tonnes/po²).
